# EUROPÄISCHE PATENTSCHRIFT

(11) **EP 2 681 981 B1**
(45) Veröffentlichungstag und Bekanntmachung des Hinweises auf die Patenterteilung: **19.10.2016**
(21) Anmeldenummer: 11741098.5
(22) Anmeldetag: 29.06.2011
(51) Int. Cl.: H05K 13/06, H01B 13/012

(54) **BEARBEITUNGSSTATION SOWIE VERFAHREN ZUR AUTOMATISIERTEN FERTIGUNG VON KABELSÄTZEN SOWIE BEARBEITUNGSEINHEIT FÜR EINE SOLCHE BEARBEITUNGSSTATION**
PROCESSING STATION AND METHOD FOR THE AUTOMATED MANUFACTURE OF CABLE HARNESSES AND PROCESSING UNIT FOR SUCH A PROCESSING STATION
STATION D'USINAGE, PROCÉDÉ DE PRODUCTION AUTOMATISÉE DE FAISCEAUX DE CÂBLE ET UNITÉ D'USINAGE POUR UNE TELLE STATION D'USINAGE

(30) Priorität: 04.03.2011 DE 102011012998
(43) Veröffentlichungstag der Anmeldung: 08.01.2014
(73) Patentinhaber: LEONI Bordnetz-Systeme GmbH, 97318 Kizingen (DE)
(72) Erfinder: STALLWITZ, Markus, 91126 Rednitzhembach (DE); DREYER, Christian, 55758 Niederwörresbach (DE); REITER, Daniel, 97070 Würzburg (DE)
(74) Vertreter: FDST Patentanwälte
(86) Internationale Anmeldenummer: PCT/EP2011/003214
(87) Internationale Veröffentlichungsnummer: WO 2012/119618

(56) Entgegenhaltungen:
- DE-A1-102008 022 337
- DE-U1-202007 012 534
- US-A- 5 851 288

## Beschreibung

Die Erfindung betrifft eine Bearbeitungsstation sowie ein Verfahren zur automatisierten Fertigung von aus einer Mehrzahl von Einzelleitungen bestehenden Kabelsätzen mit den Oberbegriffen des Anspruchs 1 beziehungsweise des Anspruchs 14. Die Erfindung betrifft weiterhin eine Bearbeitungseinheit für eine derartige Bearbeitungsstation.

Eine derartige Vorrichtung und ein derartiges Verfahren sind aus der DE 10 2008 022 337 A1 zu entnehmen.

Unter Kabelsatz wird allgemein ein vorkonfektioniertes Leitungsbündel verstanden, bei dem eine Mehrzahl von Einzelleitungen entsprechend einem vordefinierten Verlauf oder Layout und in definierter Länge miteinander verbunden sind. Kabelsätze weisen üblicherweise eine verzweigte Struktur auf mit einer Mehrzahl von Verästelungen oder Abzweigungen. Die Einzelleitungen weisen eine begrenzte Länge auf, bei dem Kabelsatz handelt es sich daher insgesamt um ein vorgefertigtes, vorkonfektioniertes Stückgut. An den einzelnen Enden der Einzelleitungen sind oftmals bereits Kontaktelemente wie Stecker oder dergleichen angeschlagen. Derartige Kabelsätze werden insbesondere auch in der Automobilindustrie, beispielsweise zur elektrischen Verbindung einer Mehrzahl von Verbrauchern mit einer zentralen Verteiler- oder Steuereinheit eingesetzt.

Die Fertigung eines derartigen Kabelsatzes wird heutzutage in weiten Bereichen noch manuell ausgeführt. Hierzu werden zunächst die für den Kabelsatz erforderlichen Einzelleitungen auf einem sogenannten Montage- oder Kabelbrett entsprechend dem definierten und gewünschten Verlauf verlegt. Dabei werden sie von Haltern aufgenommen. Anschließend wird das auf diese Weise aus den Einzelleitungen ausgebildete lose Leitungsbündel fixiert, indem eine Bandierung um die Einzelleitungen angebracht wird. Dies erfolgt manuell beispielsweise mit speziellen selbstklebenden Bändern. Aus der DE 10 2008 022 337 A1 ist eine Vorrichtung sowie ein Verfahren für ein automatisiertes Anbringen einer solchen Bandierung zu entnehmen.

Für die Bandierung bieten sich unterschiedliche Möglichkeiten an, nämlich eine sogenannte Vollbandierung, bei der das Leitungsbündel vollkommen mit der Bandierung umgeben ist oder auch eine sogenannte Sparbandierung, bei der das Leitungsbündel nur an Teilbereichen von der Bandierung umgeben ist. Zur Vermeidung von Klappergeräuschen im späteren Einsatz werden spezielle Tapes oder Bandierungen, nämlich sogenannte Flauschbänder eingesetzt. Die Bandierung weist daher je nach Einsatzort des Kabelsatzes unterschiedliche Funktionen auf. Die Hauptfunktion besteht in der Verbindung der Einzelleitungen. Daneben dient die Bandierung oftmals auch zur Befestigung von Halterungselementen oder zusätzlichen Elementen. Weiterhin dient die Bandierung als mechanischer Schutz, als Klapperschutz etc. Bei Bedarf wird das Leitungsbündel zumindest in Teilbereichen mit einem geschäumten Körper umgeben, um beispielsweise einen sogenannten formstabilen Kabelsatz auszubilden, bei dem die Abzweigungen und Verästelungen in ihrer Geometrie fixiert sind. Für derartige geschäumte Kabelsätze wird das Leitungsbündel üblicherweise in eine Werkzeugform (Schäumform) eingelegt, in die anschließend ein aufschäumbares Material, beispielsweise ein PU-Material eingebracht wird.

Da es sich bei diesen Kabelsätzen nicht um Meterware, also Endlosware handelt und die Kabelsätze sich zudem durch eine Vielzahl von Verzweigungen und Verästelungen auszeichnen, ist das Anbringen einer solchen Bandierung bis heute nicht automatisiert. Ein Kabelsatz weist typischerweise nämlich nur sehr kurze geradlinige Abschnitte ohne Verästelungen auf, die üblicherweise lediglich im Bereich von bis zu einigen 10 cm liegen.

Ausgehend hiervon liegt der Erfindung die Aufgabe zugrunde, ein automatisiertes Zusammenfügen der Einzelleitungen zur Herstellung eines Kabelsatzes zu ermöglichen.

Die Aufgabe wird gemäß der Erfindung gelöst durch eine Bearbeitungsstation mit den Merkmalen des Anspruchs 1, durch eine Bearbeitungseinheit mit den Merkmalen des Anspruchs 12 sowie mit einem Verfahren mit den Merkmalen des Anspruchs 14.

Die nachfolgend angeführten Vorteile und bevorzugten Ausgestaltungen jeweils wechselseitig sinngemäß auf die Bearbeitungsstation, das Verfahren sowie die Bearbeitungseinheit übertragbar.

Zur automatisierten Fertigung von aus Einzelleitungen bestehenden Kabelsätzen, insbesondere zum Verbinden der Einzelleitungen nach Art einer Bandierung, wird ein aus den Einzelleitungen bestehendes, loses Leitungsbündel, welches einen vorgegebenen und verzweigten Verlauf mit üblicherweise einer Vielzahl von Abzweigungen und Verästelungen aufweist, von einer Trägereinheit gehalten, an dieser also vorfixiert. Unter losem Leitungsbündel wird hierbei die Nebeneinander-Anordnung der Einzelleitungen entsprechend dem vorgesehenen Verlauf ohne Bandierung oder ähnlichem verstanden. Die Einzelleitungen liegen daher lose nebeneinander, werden allenfalls von Halteelementen der Trägereinheit vorfixiert. Im zweiten Schritt werden die Einzelleitungen mit Hilfe einer Bearbeitungseinheit automatisiert aneinander nach Art einer Bandierung fixiert. Hierzu weist die Bearbeitungseinheit eine Fixiereinheit auf, die ein Fixiermittel auf das lose Leitungsbündel aufbringt, so dass die Einzelleitungen durch das Fixiermittel miteinander verbunden sind. Das Fixiermittel ersetzt daher die Bandierung. Zum Aufbringen des Fixiermittels werden die Bearbeitungseinheit und das Leitungsbündel vorzugsweise mit Hilfe eines Manipulators relativ zueinander in einer Bearbeitungsrichtung entlang des Leitungsbündels verfahren.

Die Trägereinheit ist vorzugsweise nach Art eines herkömmlichen Montage- oder Kabelbretts ausgebildet und weist - je nach Größe des Kabelsatzes - eine Fläche von bis zu einigen m² auf, auf der das Leitungsbündel entsprechend dem vorgesehenen Verlauf, also der vorgesehenen verzweigten und verästelten Geometrie des Kabelsatzes verlegt ist. Bei den Einzelleitungen handelt es sich üblicherweise um isolierte Leiteradern aus einem leitfähigen Material wie beispielsweise Kupfer, Aluminium oder Legierungen hiervon.

Die Trägereinheit weist als Halteelemente für das Leitungsbündel vorzugsweise Stangenhalterungen auf, die endseitig beispielsweise eine gabel- oder halbringförmige Aufnahme ausbilden, in die das Leitungsbündel eingelegt wird. Das Leitungsbündel wird daher beabstandet von einer Ebene gehalten, beispielsweise ein plattenartiger Träger, so dass es vollumfänglich von der Bearbeitungseinheit umgriffen werden kann.

Durch den Ersatz der bisher üblichen Bandierung mittels Bändern durch das Aufbringen des Fixiermittels beispielsweise mit Hilfe eines Sprüh- oder Spritzverfahrens ist ein automatisiertes Fixieren der Einzelleitungen aneinander nach Art einer Bandierung in wirtschaftlicher und zugleich prozesssicherer Weise ermöglicht, so dass insgesamt ein hoher Automatisierungsgrad bei der Kabelsatzfertigung erreicht ist. Eine aufwändige manuelle Bandierung der Einzelleitungen aneinander entfällt damit. Es sind mit dieser Ausgestaltung durch eine geeignete Ansteuerung sowohl Vollbandierungen als auch sogenannte Spot- oder Sparbandierungen ermöglicht.

Der Manipulator ist beispielsweise ein Aktuator, welcher die Bearbeitungseinheit in xyz-Richtung verfahren kann und insbesondere ergänzend auch eine Rotation um die durch die Bearbeitungsrichtung definierte Achse erlaubt. Vorzugsweise handelt es sich bei dem Manipulator um einen Roboterarm eines mehrachsigen Industrieroboters, beispielsweise eines sogenannten 6-achsigen Industrieroboters. Mit diesem ist eine Vielzahl von Freiheitsgraden ermöglicht. Dadurch ist eine hohe Designfreiheit und hohe Flexibilität erreicht, was insbesondere bei den unterschiedlichen Anforderungen und Ausgestaltungen bzw. Typen an Kabelsätzen von besonderem Vorteil ist.

Für die Ausübung der Relativbewegung zwischen Bearbeitungseinheit und dem Leitungsbündel wird vorzugsweise die Bearbeitungseinheit von einer Roboterhand eines mehrachsigen Industrieroboters geführt. Alternativ besteht auch die Möglichkeit, die gesamte Trägereinheit zu führen und die Bearbeitungseinheit ortsfest zu belassen.

Das Fixiermittel weist beim Auftragen eine flüssige oder zähflüssige Konsistenz auf und härtet nach dem Aufbringen auf das Leitungsbündel aus. Hierdurch ist ein prozesssicheres Aufbringen des Fixiermittels ermöglicht. Nach dem Aushärten umgibt das Fixiermittel das Leitungsbündel vorzugsweise nach Art eines Bandes oder eines Mantels und hält auf diese Weise die Einzelleitungen zusammen.

Als Fixiermittel wird dabei ein aushärtbares Kunststoff-Harz herangezogen. Hierbei kann es sich auch um ein Zwei-Komponenten-System handeln. Aushärtbare Harzsysteme sind in weiten Bereichen bekannt. Vorzugsweise wird ein geeignetes Harzsystem gewählt, welches zum einen ein prozesssicheres Verarbeiten ermöglicht und welches zum anderen nach dem Aufbringen möglichst schnell, vorzugsweise unmittelbar aushärtet, um möglichst hohe Prozessgeschwindigkeiten zu ermöglichen. Insbesondere ist eine Verfahrgeschwindigkeit der Bearbeitungseinheit relativ zum Leitungsbündel von 100mm pro Sekunde vorgesehen, d.h. das Harzsystem muss eine ausreichend schnelle Aushärtung erlauben. Vorzugsweise ist der Aushärtvorgang zumindest zu einem Großteil beendet, sobald die Bearbeitungseinheit die jeweilige Stelle des Leitungsbündels vollständig überfahren hat. Die Aushärtung des Harzes erfolgt daher quasi instantan unmittelbar nach dem Auftragen auf das Leitungsbündel.

Gemäß einer besonders vorteilhaften Ausgestaltung ist die Bearbeitungseinheit zum zumindest teilweisen Umgreifen des Leitungsbündels ausgebildet, so dass die Bearbeitungseinheit beim Bearbeitungsverfahren in radialer Richtung an das Leitungsbündel herangefahren werden kann. Die Bearbeitungseinheit weist hierzu vorzugsweise zumindest zwei zueinander verfahrbare Teilarme auf, die im geschlossenen Zustand die Einzelleitungen vorzugsweise vollständig nach Art eines Ringes umgreifen. Die beiden Teilarme sind vorzugsweise zueinander mit Hilfe eines Stellelements, beispielsweise eines Linearantriebs verschiebbar oder auch über eine Gelenkverbindung miteinander verbunden. Die beiden Teilarme sind bevorzugt über einen nach Art eines Bajonettverschlusses ausgebildeten Verschluss miteinander arretierbar.

Alternativ oder ergänzend zu der zweiteiligen Ausgestaltung ist die Bearbeitungseinheit C- oder U-förmig ausgebildet, so dass über den offenen Bereich das Leitungsbündel in den durch die Bearbeitungseinheit definierten Zentralraum eingeführt werden kann.

Diese Ausgestaltung erlaubt ein effizientes, prozesssicheres Aufbringen des Fixiermittels auch bei den komplexen Kabelsatz-Geometrien mit mehreren Verzweigungen. Insbesondere können dadurch auch Hindernisse, wie sie beispielsweise durch die Stabhalterungen gebildet sind, berücksichtigt werden, indem entweder die Öffnung der gabelförmigen Bearbeitungseinheit in eine entsprechende Orientierungslage gebracht wird, bzw. indem die beiden Teilarme etwas geöffnet werden.

In bevorzugter Ausgestaltung ist hierbei vorgesehen, dass die beiden Teilarme symmetrisch bezüglich einer Trennebene ausgebildet sind und die gleichen Bauteile aufweisen. Insbesondere ist dabei vorgesehen, dass jeder der Teilarme die gleichen Bauteile aufweist, insbesondere ein oder mehrerer Fixiereinheiten und / oder Komprimiereinheiten und / oder Aushärteeinheiten.

Gemäß einer bevorzugten Ausgestaltung ist ergänzend die Verwendung von mehreren unterschiedlichen Fixiermitteln vorgesehen, so dass - je nach Anforderung - entweder bei einem Leitungsbündel oder bei verschiedenen Leitungsbündeln unterschiedliche Fixiermittel eingesetzt werden können, ohne dass ein Werkzeugwechsel erforderlich ist. Die einzelnen Düsen sowie eventuelle Aushärteeinheiten werden hierbei vorzugsweise auf das jeweilige Harzsystem angepasst. Bei dieser Ausführungsvariante umfasst die Bearbeitungsstation daher mehrere Vorratsbehälter für die unterschiedlichen Fixiermittel (unterschiedliche Harzsysteme).

Vorzugsweise ist allgemein eine Strukturierung des aufgebrachten Fixiermittels durch Aufbringen von Beflockungsmaterial wie beispielsweise Fasern oder andere Festpartikel vorgesehen. Hierdurch werden die gewünschten Eigenschaften beispielsweise zum Scheuerschutz oder Schallschutz geeignet eingestellt. Hierdurch können auch sogenannte "Flauschspender" nachgebildet werden.

Bei einem gewünschten dicken Materialauftrag werden vorzugsweise mehrere Schichten aufgetragen, wobei hier insbesondere auch ein abwechselndes Aufbringen von Fixiermittel und Fasermaterial (Beflockungsmittel) vorgesehen ist.

In bevorzugter Weiterbildung werden mit Hilfe des Fixiermittels zugleich auch weitere Bauteile, wie Klipse oder sonstige Befestigungselemente am Leitungsbündel befestigt, entweder an den Einzelleitungen oder auch an bereits angeschlagenen Steckverbindern. Diese Bauteile werden hierbei an der gewünschten Anbaulage vorfixiert und mit Hilfe des Fixiermittels zuverlässig befestigt.

In zweckdienlicher Ausgestaltung werden Harz- oder Lacksysteme verendet, die nach dem Aushärten eine ausreichende Steifigkeit und Härte besitzen, um beispielsweise das gesamte Leitungsbündel zumindest in Bereichen formstabil auszuführen.

Auch besteht die Möglichkeit, direkt aus dem aufgebrachten Fixiermittel Bauteile wie Klipse oder Einsteckpins (zum Einstecken in Bohrlöchern in einem Blechbauteil zu befestigen) auszubilden.

Zum dosierten Aufbringen des Fixiermittels ist zweckdienlicherweise zumindest eine Düse oder Dosiernadel als Fixiereinheit oder als Teil der Fixiereinheit vorgesehen. In zweckdienlicher Weiterbildung sind insbesondere mehrere Düsen vorgesehen, die in Umfangsrichtung verteilt angeordnet sind, also auf einem Kreis oder einem Kreisbogen liegend. Vorzugsweise umschließen die Düsen dabei im Betrieb das Leitungsbündel zumindest weitgehend ringförmig. Durch diese Ausgestaltung ist ein vollständiges um den Umfang verlaufendes Aufbringen des Fixiermittels nach Art einer Bandierung ermöglicht. Alternativ oder auch ergänzend zu der Ausgestaltung mit mehreren Düsen, die fix angeordnet sind ist eine drehbewegliche Lagerung der zumindest einen Düse vorgesehen.

Bei den Düsen handelt es sich vorzugsweise um ansteuerbare Düsen, die über Steuersignale, die von einer Steuereinheit vorgegeben werden, geöffnet und geschlossen werden. Dies erlaubt ein sehr flexibles Aufbringen des Fixiermittels mit unterschiedlichen Auftragsraten und erlaubt insbesondere das Aufbringen des Fixiermittels nach Art unterschiedlicher Bandierungsarten, beispielsweise eine Vollbandierung oder auch eine Sparbandierung, bei der das Fixiermittel schraubenlinienförmig auf das Leitungsbündel aufgetragen wird. Dies wird beispielsweise durch eine sukzessive Ansteuerung der verteilt angeordneten Düsen erreicht. Alternativ oder ergänzend wird dies durch eine Drehbewegung der zumindest einen Düse erzielt.

Durch die sukzessive Ansteuerung bzw. durch eine Rotation der zumindest einen Düsen um das Leitungsbündel werden je nach Anforderung in bevorzugter Ausgestaltung strukturierte Muster des Fixiermittels aufgebracht. Anstelle einer vollständigen Drehbewegung ist eine Oszillation über einen beschränkten Winkelbereich von beispielsweise bis zu 120° oder bis zu 180° vorgesehen. Dadurch wird beispielsweise eine netzartige Struktur als Bandierung ausgebildet. Je nach Oszillationsfrequenz und Vorschubgeschwindigkeit kann hier eine sehr engmaschige (bis hin zur vollständigen Bedeckung der Oberfläche) oder auch eine sehr weitmaschige Struktur ausgebildet werden. Die Oszillation / Rotation der Düsen wird alternativ nach Art einer Quasi-Rotation auch durch die sukzessive Ansteuerung von feststehenden Düsen erreicht.

Insgesamt ist vorzugsweise eine Mehrzahl von Düsen vorgesehen, die nach Art eines Arrays, beispielsweise ringförmig oder halbringförmig angeordnet sind. Für großflächige Auftragungen sind die Düsen vorzugsweise als Schlitzdüsen ausgebildet.

Die Düsen sind gemäß einer bevorzugten Variante als Piezodüsen oder Piezodosierer ausgebildet, das Ausstoßen des Fixiermittels erfolgt daher mit Hilfe des piezoelektrischen Effektes.

In zweckdienlicher Weiterbildung ist vorgesehen, dass mit Hilfe des Manipulators die Bearbeitungseinheit als Ganzes in Umfangsrichtung um das Leitungsbündel herum zur Ausübung der Rotation verfahren wird.

Kabelsätze zeichnen sich allgemein durch eine sehr hohe Vielfalt und hohe Variabilität hinsichtlich ihrer Komplexität und Größe aus. Um bei einer Bearbeitungseinheit eine Vielzahl von unterschiedlichen Kabelsatztypen bearbeiten zu können, ist eine gesteuerte radiale Zustellung der Düsen in Richtung zu einer zentralen Achse hin vorgesehen. Durch diese Maßnahme kann daher die Düse immer in einem optimalen Abstand zum Leitungsbündel gebracht werden. Vorzugsweise ist die Düse dabei an einem Kipphebel gelagert, so dass die Zustellbewegung in radialer Richtung mit Hilfe einer Schwenkbewegung erfolgt. Bei der Anordnung von mehreren Düsen sind vorzugsweise mehrere der Düsen über einen gemeinsamen Antrieb miteinander gekoppelt, so dass eine synchrone Bewegung der Düsen erfolgt.

Im Hinblick auf eine möglichst schnelle Aushärtung ist an der Bearbeitungseinheit eine Aushärteeinheit angebracht. Die Bearbeitungseinheit ist daher insgesamt multifunktional ausgebildet und weist neben der Funktion des Aufbringens des Fixiermittels auch die Funktion des Aushärtens auf. Je nach Wahl des Härtsystems können hierbei unterschiedliche Aushärteinheiten vorgesehen sein. Bei UVhärtenden Harzsystemen ist beispielsweise eine Lichtquelle, insbesondere UV-Lichtquelle vorgesehen, die das aufgebrachte Fixiermittel bestrahlt. Vorzugsweise ist dabei jeder einzelnen Düse eine eigene Aushärteeinheit bzw. ein eigenes Aushärtelement wie beispielsweise eine Lichtquelle zugeordnet.

Alternativ zu der UV-Lichtquelle wird zweckdienlicherweise eine Wärmequelle angeordnet, beispielsweise eine Infrarot-Strahlungsquelle. In einer bevorzugten Variante ist für ein Luft-härtendes System die Aushärteeinheit als eine Gasströmungseinheit ausgebildet, über die ein Gas mit Überdruck in Richtung des aufgebrachten Fixiermittels geleitet wird. Hierzu sind zweckdienlicherweise Gasdüsen vorgesehen. Alternativ zu gerichteten, in etwa punktförmigen Düsen ist in einer alternativen Ausgestaltung eine großflächige Strömungsöffnung vorgesehen, die sich zumindest über einen Teilbereich des Umfangs entlang einer Kreisbogenlinie erstreckt. Insbesondere ist dabei zur Ausbildung eines ringförmigen Strömungsmantels eine Ringdüse vorgesehen. Im Falle einer solchen Gasströmungs-Einheit ist daher auch insbesondere ein Lüfter zur Erzeugung des Gasstroms oder / und eine druckbehaftete Gasquelle vorgesehen. Alternativ erfolgt der Anschluss an ein Gasversorgungssystem.

In besonders bevorzugter Ausgestaltung ist hierbei vorgesehen, dass zwischen zwei unterschiedlichen Gasarten umgeschaltet werden kann. Vorzugsweise sind zumindest zwei unterschiedliche Gasversorgungen bereitgestellt, zwischen denen mit einer geeigneten Steuerung, beispielsweise mit Hilfe eines Umschaltventils, umgeschaltet wird. Einige Harzsysteme zeigen ein unterschiedliches Aushärteverhalten in Abhängigkeit des gewählten Gases, was auf diese Weise sinnvoll ausgenutzt wird. So sind beispielsweise Harzsysteme bekannt, die beim Beströmen mit sauerstoffhaltigem Gas (Luft) an ihrer Oberfläche klebrig bleiben, jedoch unter Inertgas, beispielsweise Stickstoff, eine klebefreie Oberfläche ausbilden. Dies wird beispielsweise ausgenutzt, falls die Oberfläche des Fixiermittels mit Fasern / Partikeln nach Art einer Beflockung versehen werden soll.

Zweckdienlicherweise wird das Gas mit einem ausreichenden Überdruck, beispielsweise von einigen bar, gegen das Fixiermittel gepresst, so dass dieses auch ein Stück weit in das Innere des Leitungsbündels eindringt, so dass eine intensivere Verbindung der Einzelleitungen erzielt wird.

Die Gaszuströmung wird zweckdienlicherweise alternativ oder ergänzend auch zur Strukturierung des Fixiermittels herangezogen, d.h. das aufgebrachte Fixiermittel wird nach dem Aufbringen durch die Gasströmung in gewisser Weise versetzt, so dass sich beispielsweise Bereiche mit unterschiedlicher Materialstärke ausbilden. Insbesondere lässt sich dadurch eine oszillierende, wellenartige Oberflächenstruktur des Fixiermittels ausbilden. Hierdurch kann beispielsweise in gewisser Weise eine Wellrohr-Eigenschaft herbeigeführt werden mit radial abstehenden Rippen.

Diese Strukturierung mit variabler Materialdicke des Fixiermittels kann allgemein auch ohne die Gaszuführungseinheit erfolgen.

Zu Strukturierungszwecken ist in einer Ausführungsvariante eine separate, zusätzliche Gaszuführungseinheit mit entsprechender Düsenanordnung zu der Aushärteeinheit vorgesehen, die der Aushärteeinheit vorgeschaltet ist.

Gemäß einer bevorzugten Weiterbildung ist eine Komprimierungseinheit vorgesehen, mit deren Hilfe die Einzelleitungen vor dem Aufbringen des Fixiermittels komprimiert und zu einem Bündel mit definiertem Durchmesser zusammengepresst werden.

Die Komprimierungseinheit ist dabei derart ausgebildet, dass die Einzelleitungen in radialer Richtung zusammengedrückt werden, vorzugsweise zumindest im Wesentlichen konzentrisch um eine Mitten- oder Zentralachse. Die Komprimierungseinheit weist dabei vorzugsweise einzelne Komprimierelemente auf, die um den Umfang verteilt angeordnet sind. Die einzelnen Komprimierelemente sind beispielsweise als Kreisbogen- oder Ringsegmente ausgebildet, die in radialer Richtung beispielsweise mit Hilfe eines Stempels verfahrbar sind. Gemäß einer bevorzugten Ausgestaltung werden die Komprimierelemente mit Hilfe einer Schwenkbewegung in radialer Richtung versetzt. Sie sind daher randseitig an der Bearbeitungseinheit schwenkbar gelagert. Der Antrieb erfolgt über eine geeignete, ansteuerbare Antriebseinheit. Zweckdienlicherweise sind die Komprimierelemente als einfache Stangen ausgebildet. Die Bewegungen der einzelnen Komprimierelemente sind aufeinander abgestimmt, um eine konzentrische Kompression zu erreichen.

Die Komprimierungseinheit ist dabei zweckdienlicherweise Teil der Bearbeitungseinheit. Diese weist insbesondere die Einheiten Fixiereinheit sowie Komprimierungseinheit auf. Bei Bedarf und in zweckdienlicher Weiterbildung ist auch die dritte Funktionseinheit, nämlich die Aushärteeinheit, in der Bearbeitungseinheit integriert.

Insgesamt ist die Bearbeitungseinheit nach Art eines einheitlichen Werkzeugkopfes ausgebildet, welcher entlang des Leitungsbündels verfahren wird. Mit nur einem Überstreichen des Leitungsbündels mit Hilfe dieser Bearbeitungseinheit werden daher zunächst die Einzelleitungen komprimiert, anschließend wird das Fixiermittels aufgebracht und danach erfolgt das Aushärten. Die einzelnen Funktionseinheiten folgen dabei unmittelbar aufeinander. Allgemein weist die Bearbeitungseinheit einen Träger auf, an dem - in Bearbeitungsrichtung betrachtet - eingangsseitig die Komprimierungseinheit, anschließend daran die Fixiereinheit und schließlich die Aushärteeinheit angeordnet ist. Dadurch ist insgesamt eine sehr kompakte Ausgestaltung erreicht und es sind auch hohe Prozessgeschwindigkeiten ermöglicht. Diese kompakte Bauweise erlaubt ein einfaches Handling auch bei komplexen Kabelsatz-Geometrien. Durch die kompakte Ausgestaltung kann die Bearbeitungseinheit, also die einzelnen Funktionseinheiten sehr nah an das Leitungsbündel auch im Bereich von Abzweigungen herangeführt werden.

Zusammenfassend zeichnet sich die Bearbeitungseinheit, die Bearbeitungsstation sowie das Verfahren in Kombination durch folgende Funktionen / Funktionseinheiten aus, die insbesondere durch ihr Zusammenwirken ein prozesssicheres, automatisiertes Fixieren der Einzelleitungen eines Leitungsbündels eines Kabelsatzes nach Art einer Bandierung ermöglichen:
- Bündeln / Komprimieren der Einzelleitungen mit Hilfe der Komprimierungseinheit und Zusammenhalten der Einzelleitung bis zum Auftragen des Fixiermittels (die Komprimierungseinheit ist der Fixiereinheit unmittelbar (< 5 cm) vorgeschaltet,
- Auftragen des Fixiermittels mit Hilfe der Fixiereinheit, wobei das Fixiermittel ein insbesondere UV-härtendes Harzsystem ist
- optional eine Strukturierung des noch nicht ausgehärteten Harzes mittels eines Gasstromes mit Hilfe der Gaszuführeinheit
- Aushärten des Harzes mittels der Aushärteeinheit.

Sämtliche Funktionseinheiten sind dabei innerhalb der nach Art eines Werkzeugkopfes ausgebildeten Bearbeitungseinheit integriert. Diese ist dabei vorzugsweise zum Umgreifen des Leitungsbündels und insbesondere aus zwei Teilarmen ausgebildet.

Ausführungsbeispiele der Erfindung werden im Folgenden anhand der Figuren näher erläutert. Es zeigen jeweils in teilweise schematischen Darstellungen:
- Fig. 1: eine grob vereinfachte Aufsicht auf eine Bearbeitungsstation zur automatisierten Fertigung eines Kabelsatzes,
- Fig. 2: eine stark vereinfachte und schematisierte Seitendarstellung einer Bearbeitungseinheit und Trägereinheit,
- Fig. 3A,B: eine perspektivische Ansicht sowie eine Vorderansicht einer teilweise vereinfacht dargestellten Bearbeitungseinheit gemäß einer ersten Ausführungsvariante,
- Fig. 4A, B: eine perspektivische Vorderansicht (Fig. 4A) sowie Rückansicht (Fig. 4B) in teilweise vereinfachter Darstellung gemäß einer zweiten Ausführungsvariante und
- Fig. 5A, B: eine perspektivische Vorderansicht (Fig. 5A) sowie eine Rückansicht (Fig. 5B) in teilweise vereinfachter Darstellung einer dritten Ausführungsvariante der Bearbeitungseinheit.

In den Figuren sind gleichwirkende Teile mit den gleichen Bezugszeichen versehen.

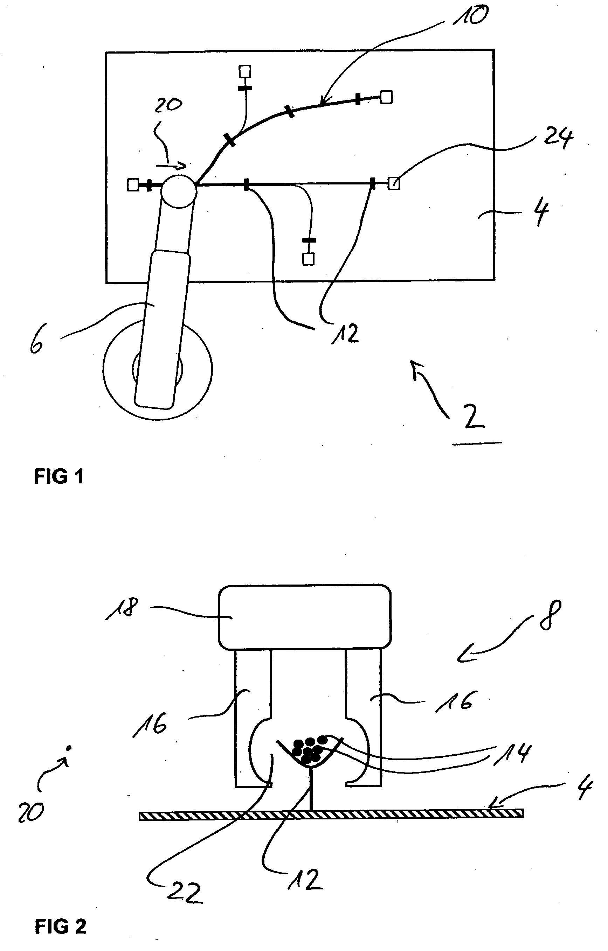

Das grundsätzliche Verfahren zur automatisierten Fertigung von Kabelsätzen wird zunächst anhand der Fig. 1 und 2 näher erläutert. Wie anhand der Fig. 1 zu erkennen ist, umfasst eine Bearbeitungsstation 2 eine als Kabelbrett ausgebildete Trägereinheit 4, einen Manipulator 6, im Ausführungsbeispiel ein mehrachsiger Industrieroboter sowie eine Bearbeitungseinheit 8 (Fig. 2), die am Manipulator 6, nämlich an einer Roboterhand befestigt ist.

Der Manipulator 6 weist mehrere Freiheitsgrade auf, um die Bearbeitungseinheit 8 relativ zu der Trägereinheit 4 an beliebige Positionen verfahren zu können. Insbesondere bietet der Manipulator 6 zumindest einen rotorischen Freiheitsgrad, so dass die Bearbeitungseinheit 8 mit Hilfe des Manipulators 6 insgesamt rotiert werden kann.

Auf der Trägereinheit 4 ist ein verzweigtes Leitungsbündel 10 auf Halteelementen 12 aufgelegt. Das Leitungsbündel 10 besteht dabei aus einer Mehrzahl von Einzelleitungen 14 (Fig. 2). Jede der Einzelleitungen 14 ist im Ausführungsbeispiel gebildet durch eine von einer Isolierung umgebene elektrisch leitfähige Ader. Die Halteelemente 12 sind nach Art von Stabhaltern ausgebildet mit einer gabelförmigen Aufnahme, in der die Einzelleitungen 14 einliegen. Durch die Halteelemente 12 ist das Leitungsbündel 10 daher von der Oberfläche eines Montagebretts der Trägereinheit 4 beabstandet. Hierdurch ist ein Umgreifen des Leitungsbündels 10 durch die Bearbeitungseinheit 8 ermöglicht.

Wie bereits in Fig. 2 dargestellt, weist diese zwei Teilarme 16 auf, die im Ausführungsbeispiel mit Hilfe eines (linear) Aktuators 18 relativ zueinander und senkrecht zu einer Bearbeitungsrichtung 20 verschoben werden können. Im geschlossenen Zustand definieren die beiden Teilarme 16 einen kreisförmigen Zentralraum 22, in dem das Leitungsbündel 10 einliegt. Die Bearbeitungsrichtung 20 ist allgemein definiert durch die Richtung, in der die Bearbeitungseinheit 8 relativ zum Leitungsbündel 10 verfahren wird. Bei Abzweigungen ändert sich daher die Bearbeitungsrichtung 20.

Beim Leitungsbündel 10 sind die Einzelleitungen 14 zunächst nur lose aneinander gehalten. Mit Hilfe der Bearbeitungseinheit 8 wird als Fixiermittel ein aushärtbares Harz in flüssiger oder zähflüssiger Form auf das Leitungsbündel 10 sukzessive in Bearbeitungsrichtung 20 aufgebracht. Am Ende dieser Behandlung sind die Einzelleitungen 14 daher aneinander fixiert. Das Leitungsbündel 10 mit den dann fixierten Einzelleitungen 14 bildet den fertigen Kabelsatz.

Wie aus Fig. 1 zu entnehmen ist, sind im Ausführungsbeispiel an den Enden des Kabelsatzes jeweils Kontaktelemente 24 angebracht. Das Leitungsbündel 10 weist mehrere Verzweigungen auf. Aufgrund dieser Verzweigungen war es bisher nicht möglich, in wirtschaftlich sinnvoller Weise eine Automatisierung der bisher üblichen Bandierung des Leitungsbündels 10 durchzuführen.

Aufgrund der speziellen Ausgestaltung der Bearbeitungseinheit 8 und dem grundsätzlich neuen Konzept des Aufbringens eines Fixiermittels, welches nach dem Aufbringen aushärtet und die Einzelleitungen 14 nach Art einer Bandierung fixiert, ist nunmehr in wirtschaftlich vertretbarer Weise eine automatisierte Fertigung ermöglicht. Ein besonderer Gesichtspunkt hierbei ist das grundlegende Konzept, dass die Bearbeitungseinheit 8 radial, also senkrecht zur Bearbeitungsrichtung 20 an das Leitungsbündel 10 herangeführt und dieses umgreifen kann. Im Ausführungsbeispiel ist dies durch die verstellbaren Teilarme 16 ermöglicht. Sobald eine Verzweigungsstelle oder ein sonstiges Hindernis, wie beispielsweise ein Halteelement 12 kommt, werden die Teilarme 16 geöffnet, die Bearbeitungseinheit 8 über die Verzweigungsstelle bzw. das Hindernis hinweg gefahren um anschließend mit dem Aufbringen des Fixiermittels mit geschlossenen Teilarmen 16 fortzufahren. Der Manipulator 6 und die Bearbeitungseinheit 8 werden mit Hilfe einer hier nicht näher dargestellten Steuereinheit gesteuert.

Alternativ zu der Ausgestaltung mit den beiden Teilarmen 16 besteht auch die Möglichkeit einer U- oder C-förmigen Ausgestaltung der Bearbeitungseinheit 8. In diesem Fall ist es nicht zwingend erforderlich, die Bearbeitungseinheit 8 bei Hindernissen oder Verzweigungen vom Leitungsbündel 10 zurückzuziehen. Vielmehr reicht eine geeignete Rotation der Bearbeitungseinheit 8 mit Hilfe des Manipulators 6 aus. Die einzelnen Zweige des verzweigten Leitungssatzes 10 werden je nach Bedarf nacheinander nach Art einer Bandierung mit dem Fixiermittel versehen.

Beim Betrieb wird die Bearbeitungseinheit 8 in Bearbeitungsrichtung 20 entlang des Leitungsbündels 10 verfahren. Dabei erfolgt mit der Bearbeitungseinheit 8 zunächst ein Komprimieren der Einzelleitungen 14, das Auftragen des Fixiermittels, ggf. eine Strukturierung des Fixiermittels sowie das Aushärten des Fixiermittels. Die Verfahrgeschwindigkeit beträgt dabei vorzugsweise einige cm / Sekunde bis zu etwa 10cm /Sekunde, zumindest in Bereichen ohne Hindernisse.

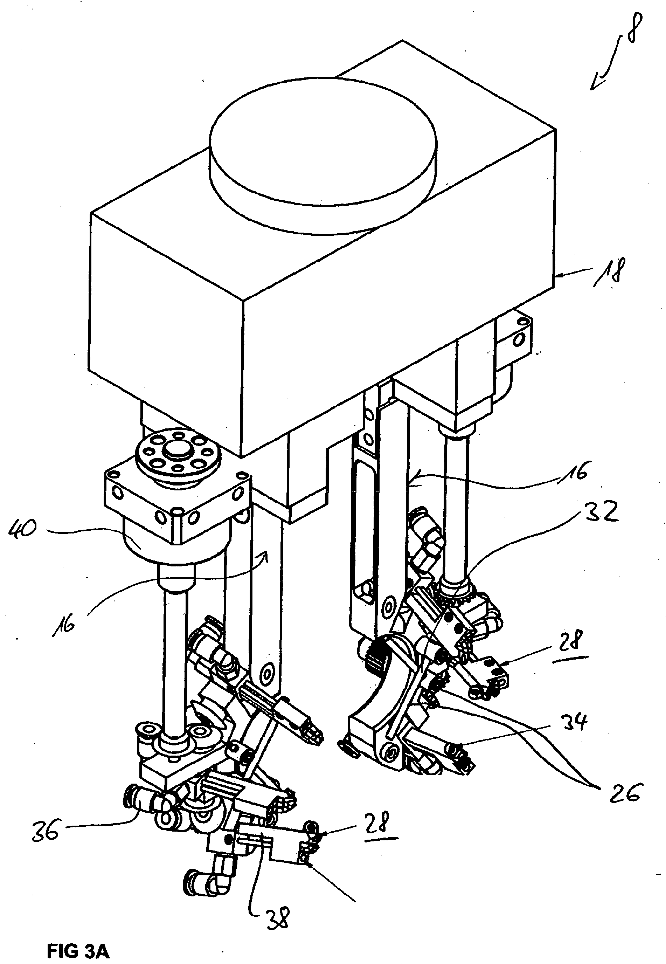

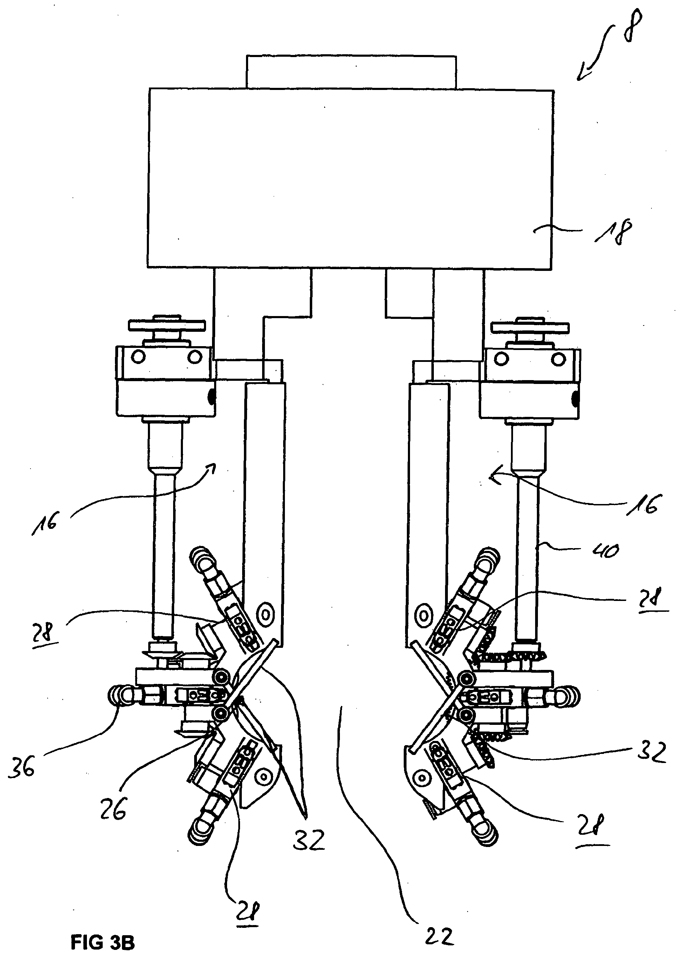

Ausführungsbeispiele für einen speziellen Aufbau der Bearbeitungseinheit 8 werden nachfolgend anhand der Figuren 3 bis 5 näher erläutert.

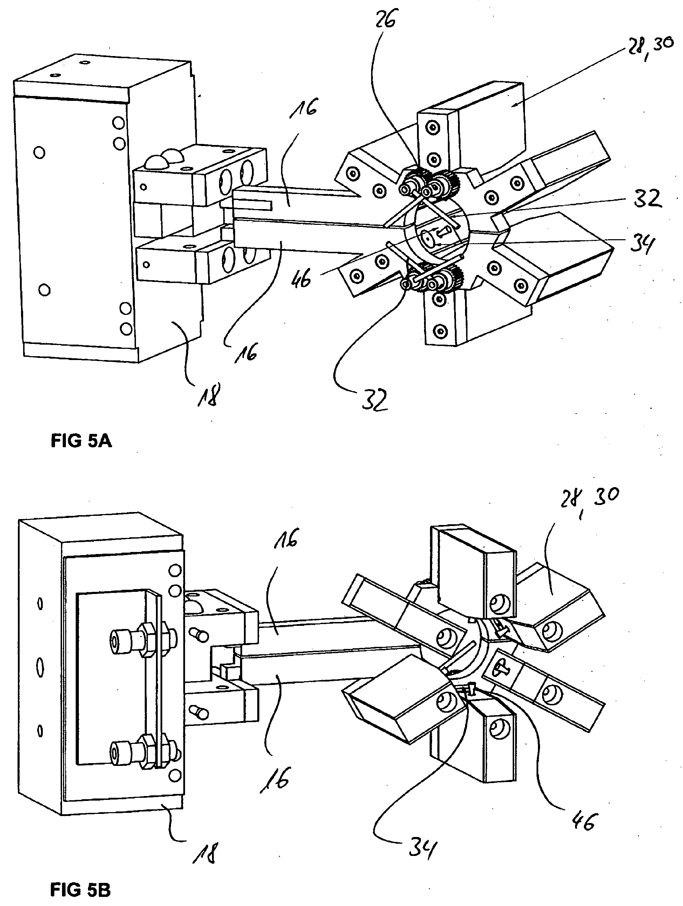

Bei allen drei Ausführungsvarianten sind zwei linear zueinander verstellbare Teilarme 16 vorgesehen, die jeweils ein holmartiges Tragelement umfassen, an dessen Ende jeweils ein halbringförmiger Bearbeitungskopf angeordnet ist. Die beiden halbringförmigen Bearbeitungsköpfe bilden im geschlossenen Zustand der Teilarme 16 einen geschlossenen Werkzeugkopf aus, der in seinem Inneren den Zentralraum 22 umschließt. Der Begriff halbring- oder ringförmig im Zusammenhang mit dem Werkzeugkopf ist hierbei weit zu verstehen und umfasst auch die Ausführungsvarianten der Figuren 3 und 5, ist also nicht zwingend auf eine kreisrunde Querschnittsgeometrie des Werkzeugkopfes beschränkt.

In allen drei Ausführungsvarianten sind im Werkzeugkopf zwei Funktionseinheiten integriert, nämlich eine eingangsseitige Komprimierungseinheit 26 sowie eine sich daran anschließende Fixiereinheit 28. Bei der Ausführungsvariante nach Fig. 5 ist zusätzlich eine sich an die Fixiereinheit 28 anschließende Aushärteeinheit 30 angeordnet, die in diesem Ausführungsbeispiel in einem gemeinsamen Modul integriert sind.

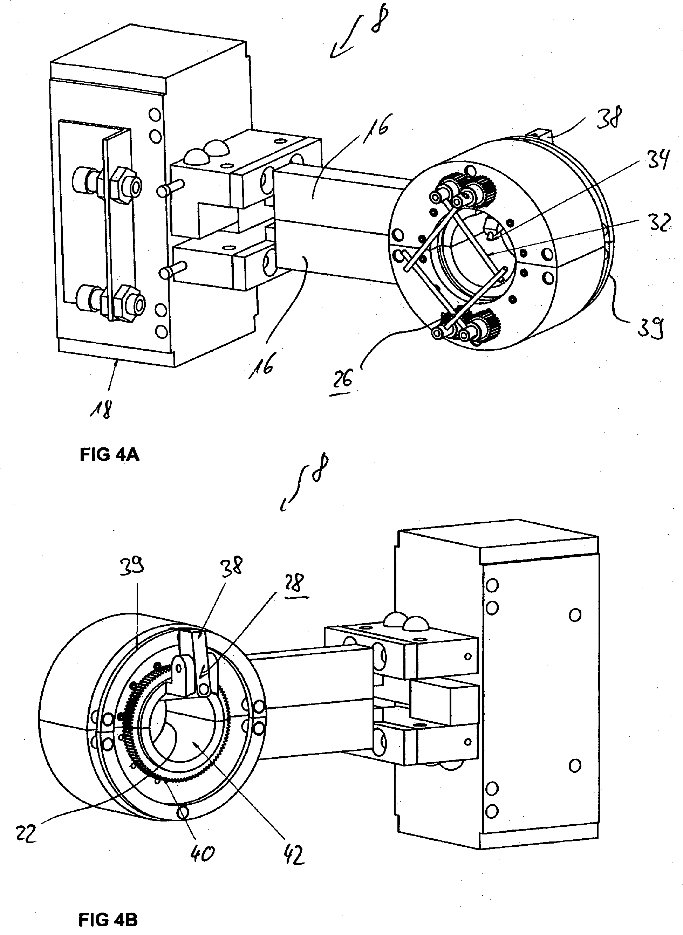

Die Komprimierungseinheit 26 ist bei allen drei Ausführungsvarianten identisch ausgebildet und weist mehrere umfangsseitig zum Zentralraum 22 angeordnete Komprimierungselemente 32 auf. Im Ausführungsbeispiel sind vier Stück vorgesehen. Diese sind dabei gebildet durch an ihrer Endseite drehbar gelagerte Stangen, die motorisch angetrieben in den Zentralraum 22 hinein verschwenkbar sind. Da sich die einzelnen Stangen kreuzen, wird beim Schwenken zum Zentralraum 22 hin das im Zentralraum 22 einliegende Leitungsbündel 10 komprimiert und weiter gebündelt. Zum Verschwenken der Stangen ist ein hier nicht näher dargestellter Antriebsmechanismus vorgesehen, welcher am Ende über eine Verzahnung zwischen zwei benachbarten Komprimierungselementen 32 für eine synchrone Bewegung auf jeweils zwei der Komprimierungselemente 32 übertragen wird, wie dies aus den Figuren 4A und 5A gut zu erkennen ist.

Die Fixiereinheiten 28 umfassen jeweils eine Düse 34, über die das Fixiermittel austritt. Das Fixiermittel wird über geeignete Zuführungen den einzelnen Fixiereinheiten 28 zugeführt. In Fig. 3A sind Leitungsanschlüsse 36 für den Anschluss von Zuführschläuchen für das im Ausgangszustand flüssige Fixiermittel vorgesehen.

Im Ausführungsbeispiel der Fig. 3 sind die Düsen 34 endseitig an schwenkbar gelagerten Armen 38 angeordnet. An der Rückseite der Arme 38 sind die Leitungsanschlüsse 36 vorgesehen. Das Verschwenken der Arme 38 erfolgt mit Hilfe eines Stellantriebs 40, wobei für jeden Teilarm 16 ein eigener Stellantrieb 40 vorgesehen ist, die jedoch miteinander synchronisiert sind. Im Ausführungsbeispiel wird die Stellbewegung vom Stellantrieb 40 über eine Antriebsachse und eine Art Zahnradgetriebe auf die einzelnen Arme 38 zur Ausübung der Schwenkbewegung übertragen.

Beim Ausführungsbeispiel der Fig. 4 ist lediglich eine einzige Fixiereinheit 28 mit lediglich einem schwenkbaren Arm 38 vorgesehen, der Arm 38 ist hierbei nach Art eines Schwenk- oder Knickhebels ausgebildet. Zur Verstellung des Armes 38 ist im Ausführungsbeispiel ein Ringelement 39 vorgesehen, welches in axialer Richtung verstellbar ist und dadurch auf den Knickhebel einwirkt, um die gewünschte Verstellung zu herbeizuführen.

Bei der in der Fig. 4 dargestellten Ausführungsvariante ist der Arm 38 um den Zentralraum 22 herum rotierbar angeordnet. Im Ausführungsbeispiel wird dies durch einen Innenrotor 42 sowie einem Antriebszahnkranz 44 ermöglicht. Durch ein hier nicht näher dargestelltes Zahnrad, welches mit dem Arm 38 verbunden ist und mit dem Antriebszahnkranz 44 kämmt, wird eine Rotation des am Innenrotor 42 befestigten Arms 38 um der Zentralraum 22 herum ermöglicht. Aufgrund der Teilarme 16 ist sowohl der Innenrotor 42 als auch den Antriebszahnkranz 44 zweiteilig ausgebildet.

Bei der Ausführungsvariante gemäß der Fig. 5 sind mehrere Moduleinheiten in etwa sternförmig am Werkzeugkopf angeordnet. Die Moduleinheiten sind dabei jeweils an einer sternförmigen Trägerplatte durch Schrauben befestigt. Jede der Moduleinheiten weist als Bestandteil eine Fixiereinheit 28 mit einer Düse 34 auf. Bei den Moduleinheiten handelt es sich insbesondere um Piezoeinheiten, die Düse 34 sind also als Piezodüsen ausgebildet, d.h. das Fixiermittel wird aus den Düsen 34 mit Hilfe des piezoelektrischen Effekts in an sich bekannter Weise ausgestoßen.

In die jeweilige Moduleinheit ist ergänzend auch noch die Aushärteeinheit 30 integriert, die in diesem Ausführungsbeispiel gebildet ist durch UV-Lichtquellen 46. Diese sind entgegen der Bearbeitungsrichtung 20 nachfolgend zu den Düsen 34 angeordnet.

### Bezugszeichenliste

- 2: Bearbeitungsstation
- 4: Trägereinheit
- 6: Manipulator
- 8: Bearbeitungseinheit
- 10: Leitungsbündel
- 12: Halteelementen
- 14: Einzelleitungen
- 16: Teilarme
- 18: Aktuator
- 20: Bearbeitungsrichtung
- 22: Zentralraum
- 24: Kontaktelemente
- 26: Komprimierungseinheit
- 28: Fixiereinheit
- 30: Aushärteeinheit
- 32: Komprimierungselemente
- 34: Düse
- 36: Leitungsanschlüsse
- 38: Arme
- 39: Ringelement
- 40: Stellantrieb
- 42: Innenrotor
- 44: Antriebszahnkranz
- 46: UV-Lichtquellen

## Patentansprüche

1. Bearbeitungsstation (2) zur automatisierten Fertigung eines aus einer Mehrzahl von Einzelleitungen (14) bestehenden Kabelsatzes mit
- einer Trägereinheit (4) zum Halten eines aus den Einzelleitungen (14) bestehenden Leitungsbündels (10) mit einem vorgegebenen auch verzweigten Verlauf,
- einer Bearbeitungseinheit (8) zur automatisierten Fixierung der Einzelleitungen (14) des Leitungsbündels (10) aneinander,
- einem Manipulator (6) zur Relativbewegung der Bearbeitungseinheit (8) zum Leitungsbündel (10),
**dadurch gekennzeichnet,**
**dass** die Bearbeitungseinheit (8) eine Fixiereinheit (28) umfasst, die zum automatisierten Aufbringen eines Fixiermittels auf das Leitungsbündel (10) ausgebildet ist, wobei als Fixiermittel ein aushärtbares Harz bereitgestellt ist.

2. Bearbeitungsstation (2) nach Anspruch 1, bei der die Bearbeitungseinheit (8) zum Umgreifen des Leitungsbündels (10) ausgebildet ist und hierzu wahlweise
- zumindest zwei zueinander verfahrbare Teilarme (16) aufweist, die in einem geschlossenen Zustand die Einzelleitungen (14) umgreifen
- C- oder U-förmig ausgebildet ist.

3. Bearbeitungsstation (2) nach einem der vorhergehenden Ansprüche, bei der mehrere unterschiedliche Fixiermittel bereitgestellt sind.

4. Bearbeitungsstation (2) nach einem der vorhergehenden Ansprüche, bei der die Bearbeitungseinheit (8) zur Strukturierung des aufgebrachten Fixiermittels ausgebildet ist, wie Aufbringen eines Feststoffmaterials oder zur Erzeugung von unterschiedlichen Materialdicken des Fixiermittels im Verlauf des Leitungsbündels (10).

5. Bearbeitungsstation (2) nach einem der vorhergehenden Ansprüche, bei der die Fixiereinhelt (28) eine Düse (34) oder mehrere um den Umfang verteilte Düsen (34) aufweist.

6. Bearbeitungsstation (2) nach Anspruch 5, bei der die zumindest eine Düse (34) um das Leitungsbündel (10) rotierbarangeordnet ist.

7. Bearbeitungsstation (2) nach Anspruch 5 oder 6, bei der die zumindest eine Düse (34) in radialer Richtung zum Leitungsbündel (10) verfahrbar ist.

8. Bearbeitungsstation (2) nach einem der Ansprüche 5 bis 7 und Anspruch 2, bei der an Jedem Teilarm (16) zumindest eine Düse (34) angeordnet ist.

9. Bearbeitungsstation (2) nach einem der vorhergehenden Ansprüche, bei der die Bearbeitungseinheit (8) eine Aushärteeinheit (30) zum Aushärten des aufgebrachte Fixiermittels aufweist, und die Aushärteeinheit (30) insbesondere wahlweise aufweist eine UV-Lichtquelle (46), eine Gaszuführungseinhelt, eine Wärmequelle.

10. Bearbeitungsstation (2) nach einem der vorhergehenden Ansprüche, bei der die Bearbeitungseinheit (8) eine Komprimierungseinheit (26) zum Komprimieren der Einzelleitungen (14) aufweist.

11. Bearbeitungsstation (2) nach Anspruch 10, bei der die Komprimierungseinheit (26) mehrere auf einen Kreisbogen verteilt angeordnete und insbesondere als drehbar gelagerte Stangen ausgebildete Komprimierungselemente (32) aufweist, mit deren Hilfe die Einzelleitungen (14) komprimiert werden.

12. Bearbeitungseinheit (8) für eine Bearbeitungsstation (2) nach einem der vorhergehenden Ansprüche, die zur automatisierten Fixierung der Einzelleitungen (14) des Leitungsbündels (10) aneinander ausgebildet ist und eine Fixiereinheit (28) aufweist, die zum automatisierten Aufbringen eines aushärtbaren Harzes als Fixiermittel auf das Leitungsbündel (10) ausgebildet ist.

13. Bearbeitungseinheit (8) nach Anspruch 12,
- die zuelnander verfahrbare Teilarme (16) aufweist, die im geschlossenen Zustand einen Zentralraum (22) ringförmig umschließen, oder die C- oder U-förmig ausgebildet ist,
- bei der zum Aufbringen eines aushärtbaren Fixiermittels um den Zentralraum (22) herum verteilt mehrere Düsen (34) angeordnet sind oder eine um den Zentralraum (22) verfahrbare Düse (34) angeordnet ist
- die eine Komprimierungseinheit (26) aufweist, die mehrere um den Zentralraum (22) herum verteilt angeordnete Komprimierungselemente (32) umfasst, die in radialer Richtung verfahrbar sind,
- die bei Bedarf eine Aushärteeinheit (30) zum Aushärten des Fixiermittels aufweist.

14. Verfahren zur automatisierten Fertigung von aus einer Mehrzahl von Einzelleitungen (14) bestehenden Kabelsätzen, bei dem ein aus den Einzelleitungen (14) bestehendes Leitungsbündel (10) mit einem vorgegebenen auch verzweigten Verlauf in einer Trägereinheit (4) gehalten wird, und mit Hilfe einer Bearbeitungseinheit (8) die Einzelleitungen (14) des Leitungsbündels (10) automatisiert aneinander fixiert werden, wobei die Bearbeitungseinheit und das Leitungsbündel (10) relativ zueinander in Bearbeitungsrichtung (20) entlang des Leitungsbündels (10) verfahren werden,
**dadurch gekennzeichnet,**
**dass** über eine Fixiereinheit (28) ein Fixiermittel auf das Leitungsbündel (10) aufgebracht wird und dass als Fixiermittel ein aushärtbares Harz verwendet wird.

## Claims

1. Processing station (2) for the automated production of a cable set consisting of a multitude of single cables (14) having
- a carrier unit (4) for holding a cable bundle (10) consisting of the single cables (14) with a predefined, also branched routing,
- a processing unit (8) to automatically fix the single cables (14) of the cable bundle (10) to one another,
- a manipulator (6) for the relative movement of the processing unit (8) to the cable bundle (10),
**characterised in that**
the processing unit (8) comprises a fixing unit (28) which is formed to automatically apply a fixing agent to the cable bundle (10), wherein a setting resin is provided as the fixing agent.

2. Processing station (2) according to claim 1 in which the processing unit (8) is formed for enclosing the cable bundle (10), and for this purpose optionally
- has at least two arm sections (16) which can be moved towards one another and enclose the single cables (14) in a closed state
- is C- or U-shaped.

3. Processing station (2) according to one of the preceding claims, in which several different fixing agents are provided.

4. Processing station (2) according to one of the preceding claims, in which the processing unit (8) is formed for structuring the applied fixing agent, such as applying a solid material, or for the production of different material thicknesses of the fixing agent in the routing of the cable bundle (10).

5. Processing station (2) according to one of the preceding claims, in which the fixing unit (28) has one nozzle (34) or several nozzles (34) distributed around the circumference.

6. Processing station (2) according to claim 5, in which at least one nozzle (34) is arranged to be rotatable around the cable bundle (10).

7. Processing station (2) according to claim 5 or 6, in which at least one nozzle (34) is able to be moved in the radial direction towards the cable bundle (10).

8. Processing station (2) according to one of claims 5 to 7 and claim 2, in which at least one nozzle (34) is arranged on every arm section (16).

9. Processing station (2) according to one of the preceding claims, in which the processing unit (8) has a setting unit (30) for setting the applied fixing agent, and the setting unit (30) in particular optionally has a UV light source (46), a gas supply unit, a heat source.

10. Processing station (2) according to one of the preceding claims, in which the processing unit (8) has a compressing unit (26) for compressing the single cables (14).

11. Processing station (2) according to claim 10, in which the compression unit (26) has several compressing elements (32) distributed on an arc and in particular formed as rotatable rods, with the aid of which the single cables (14) are compressed.

12. Processing unit (8) for a processing station (2) according to one of the preceding claims which is formed for the automated fixing of the single cables (14) of the cable bundle (10) to one another and has a fixing unit (28) that is formed for the automated application of a settable resin as a fixing agent on the cable bundle (10).

13. Processing unit (8) according to claim 12,
- that has the arm section (16) which can be moved towards one another and, in the closed state, circularly enclose a central area (22) that is C- or U-shaped,
- in which several nozzles (34) for the application of a settable fixing agent are distributed around the central area (22), or one nozzle (34) is arranged to be movable around the central area (22)
- which has a compression unit (26) which comprises several compression elements (32) distributed around the central area (22) which are movable in the radial direction,
- which if required has a setting unit (30) for setting the fixing agent.

14. Process for the automated production of cable sets consisting of a multitude of single cables (14), in which a cable bundle (10) consisting of the single cables (14) having a predetermined, also branched routing is held in a carrier unit (4), and the single cables (14) of the cable bundle (10) are automatically fixed to one another with the aid of a processing unit (8), wherein the processing unit and the cable bundle (10) can be moved relative to one another in the processing direction (20) along the cable bundle (10),
**characterised in that**
a fixing agent is applied to the cable bundle (10) via a fixing unit (28), and a settable resin is used as a fixing agent.

## Revendications

1. Poste de façonnage ou de confection (2) pour la fabrication automatisée d'un jeu de câbles ou kit de câblage constitué d'une pluralité de câbles individuels (14), comprenant
une unité de support (4) pour maintenir un faisceau de câbles (10) constitué par les câbles individuels (14), selon un tracé prescrit et également ramifié,
une unité de façonnage (8) pour assurer la fixation automatisée des uns aux autres, des câbles individuels (14) du faisceau de câbles (10),
un manipulateur (6) pour assurer le déplacement relatif de l'unité de façonnage (8) par rapport au faisceau de câbles (10),
**caractérisé**
**en ce que** l'unité de façonnage (8) comprend une unité de fixation (28), qui est conçue pour l'application d'un moyen de fixation sur le faisceau de câbles (10), une résine durcissable étant fournie en guise de moyen de fixation.

2. Poste de façonnage ou de confection (2) selon la revendication 1, dans lequel l'unité de façonnage (8) est configurée pour entourer le faisceau de câbles (10) et, à cet effet sélectivement
- présente deux bras partiels (16) déplaçables l'un par rapport à l'autre, qui, dans un état fermé, entourent les câbles individuels (14),
- ou est réalisée en forme de C ou de U.

3. Poste de façonnage ou de confection (2) selon l'une des revendications précédentes, dans lequel sont fournis plusieurs moyens de fixation différents.

4. Poste de façonnage ou de confection (2) selon l'une des revendications précédentes, dans lequel l'unité de façonnage (8) est configurée pour assurer une structuration du moyen de fixation appliqué, comme par exemple l'application d'un matériau solide, ou bien pour produire des épaisseurs de matériau différentes du moyen de fixation le long de l'étendue du faisceau de câbles (10).

5. Poste de façonnage ou de confection (2) selon l'une des revendications précédentes, dans lequel l'unité de fixation (28) présente une buse (34) ou plusieurs buses (34) réparties autour de la périphérie.

6. Poste de façonnage ou de confection (2) selon la revendication 5, dans lequel ladite au moins une buse (34) est agencée de manière à pouvoir tourner autour du faisceau de câbles (10).

7. Poste de façonnage ou de confection (2) selon la revendication 5 ou la revendication 6, dans lequel ladite au moins une buse (34) est déplaçable par rapport au faisceau de câbles (10), dans la direction radiale.

8. Poste de façonnage ou de confection (2) selon l'une des revendications 5 à 7 et la revendication 2, dans lequel sur chaque bras partiel (16) est agencée au moins une buse (34).

9. Poste de façonnage ou de confection (2) selon l'une des revendications précédentes, dans lequel l'unité de façonnage (8) comporte une unité de durcissement (30) pour assurer le durcissement du moyen de fixation appliqué, et l'unité de durcissement (30) comprenant notamment de manière sélective, une source de lumière UV (46), une unité d'alimentation en gaz, une source de chaleur.

10. Poste de façonnage ou de confection (2) selon l'une des revendications précédentes, dans lequel l'unité de façonnage (8) comprend une unité de compression (26) pour comprimer les câbles individuels (14).

11. Poste de façonnage ou de confection (2) selon la revendication 10, dans lequel l'unité de compression (26) présente plusieurs éléments de compression (32) agencés de manière répartie sur un arc de cercle et notamment réalisés sous forme de tiges montées rotatives, à l'aide desquels les câbles individuels (14) sont comprimés.

12. Unité de façonnage (8) pour un poste de façonnage ou de confection (2) selon l'une des revendications précédentes, qui est conçue pour la fixation automatisée les uns aux autres, des câbles individuels (14) du faisceau de câbles (10), et comporte une unité de fixation (28) conçue pour l'application automatisée d'une résine durcissable en guise de moyen de fixation sur le faisceau de câbles (10).

13. Unité de façonnage (8) selon la revendication 12,
- qui comporte des bras partiels (16) entourant de manière annulaire, dans l'état fermé, un espace central (22), ou bien qui est de configuration en forme C ou en forme de U,
- dans laquelle pour l'application d'un moyen de fixation durcissable, plusieurs buses (34) sont agencées de manière répartie autour de l'espace central (22), ou bien dans laquelle est agencée une buse (34) pouvant être déplacée autour de l'espace central (22),
- qui comporte une unité de compression (26) comprenant plusieurs éléments de compression (32) agencés de manière répartie autour de l'espace central (22), et déplaçables dans la direction radiale,
- et qui comporte, le cas échéant, une unité de durcissement (30) pour assurer le durcissement du moyen de fixation.

14. Procédé pour la fabrication automatisée de jeux de câbles ou kits de câblage constitués d'une pluralité de câbles individuels (14), d'après lequel un faisceau de câbles (10) constitué par les câbles individuels (14) est maintenu selon un tracé prescrit et également ramifié, dans une unité de support (4), et, à l'aide d'une unité de façonnage (8), les câbles individuels (14) du faisceau de câbles (10) sont fixés les uns aux autres de manière automatisée, l'unité de façonnage et le faisceau de câbles (10) étant déplacés de manière relative réciproque dans une direction de façonnage (20) le long du faisceau de câbles (10),
**caractérisé**
**en ce qu'**on applique un moyen de fixation sur le faisceau de câbles (10) par l'intermédiaire d'une unité de fixation (28), et en ce qu'on utilise une résine durcissable en guise de moyen de fixation.
